# EUROPEAN PATENT APPLICATION

(11) **EP 4 447 117 A1**
(43) Date of publication of application: **16.10.2024**
(21) Application number: 22904244.5
(22) Date of filing: 07.12.2022
(51) Int. Cl.: H01L 27/146, H01L 21/3205, H01L 21/768, H01L 23/522, H04N 25/70

(54) **LIGHT-RECEIVING DEVICE**

(30) Priority: 10.12.2021 JP 2021201271
(71) Applicant: Sony Semiconductor Solutions Corporation, Atsugi-shi, Kanagawa 243-0014 (JP)
(72) Inventor: HANEDA, Masaki, Atsugi-shi, Kanagawa 243-0014 (JP); KAMIBAYASHI, Takumi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/045035
(87) International publication number: WO 2023/106316

(57) **Abstract**

A light-receiving device according to an embodiment of the present disclosure includes: a first substrate including a plurality of photoelectric conversion sections that photoelectrically converts light and an accumulation section that accumulates electric charge photoelectrically converted by the photoelectric conversion sections; a second substrate stacked on the first substrate and including a readout circuit that outputs a first signal based on the electric charge accumulated in the accumulation section; and a wiring layer including a via that electrically couples the accumulation section and the readout circuit to each other. The first substrate and the second substrate are stacked to allow a first surface of the first substrate on which an element is formed and a second surface of the second substrate on which an element is formed to be opposed to each other. The via penetrates a plurality of layers in the wiring layer.

## Description

### Technical Field

The present disclosure relates to a light-receiving device.

### Background Art

There has been proposed an imaging device having a three-dimensional structure configured by attaching together a substrate including a sensor pixel, a substrate including a readout circuit, and a substrate including a logic circuit (PTL 1).

### Citation List

### Patent Literature

PTL 1: Japanese Unexamined Patent Application Publication No. 2020-88380

### Summary of the Invention

It is desired for an imaging device to have improved conversion efficiency upon conversion of electric charge into a voltage.

It is desirable to provide an imaging device that makes it possible to improve conversion efficiency.

A light-receiving device according to an embodiment of the present disclosure includes: a first substrate including a plurality of photoelectric conversion sections that photoelectrically converts light and an accumulation section that accumulates electric charge photoelectrically converted by the photoelectric conversion sections; a second substrate stacked on the first substrate and including a readout circuit that outputs a first signal based on the electric charge accumulated in the accumulation section; and a wiring layer including a via that electrically couples the accumulation section and the readout circuit to each other. The first substrate and the second substrate are stacked to allow a first surface of the first substrate on which an element is formed and a second surface of the second substrate on which an element is formed to be opposed to each other. The via penetrates a plurality of layers in the wiring layer.

### Brief Description of the Drawings

[FIG. 1] FIG. 1 is a block diagram illustrating an example of an overall configuration of an imaging device according to an embodiment of the present disclosure.
[FIG. 2] FIG. 2 is a diagram illustrating a configuration example of a pixel sharing unit of the imaging device according to an embodiment of the present disclosure.
[FIG. 3] FIG. 3 is a schematic view of an example of a cross-sectional configuration of the imaging device according to an embodiment of the present disclosure.
[FIG. 4] FIG. 4 is a diagram illustrating an example of a cross-sectional configuration of the imaging device according to an embodiment of the present disclosure.
[FIG. 5A] FIG. 5A is a diagram illustrating an example of a manufacturing method of the imaging device according to an embodiment of the present disclosure.
[FIG. 5B] FIG. 5B is a diagram illustrating an example of the manufacturing method of the imaging device according to an embodiment of the present disclosure.
[FIG. 5C] FIG. 5C is a diagram illustrating an example of the manufacturing method of the imaging device according to an embodiment of the present disclosure.
[FIG. 5D] FIG. 5D is a diagram illustrating an example of the manufacturing method of the imaging device according to an embodiment of the present disclosure.
[FIG. 5E] FIG. 5E is a diagram illustrating an example of the manufacturing method of the imaging device according to an embodiment of the present disclosure.
[FIG. 5F] FIG. 5F is a diagram illustrating an example of the manufacturing method of the imaging device according to an embodiment of the present disclosure.
[FIG. 5G] FIG. 5G is a diagram illustrating an example of the manufacturing method of the imaging device according to an embodiment of the present disclosure.
[FIG. 6] FIG. 6 is a diagram illustrating an example of a cross-sectional configuration of an imaging device according to Modification Example 1 of the present disclosure.
[FIG. 7] FIG. 7 is a diagram illustrating an example of a cross-sectional configuration of an imaging device according to Modification Example 2 of the present disclosure.
[FIG. 8] FIG. 8 is a diagram illustrating another example of the cross-sectional configuration of the imaging device according to Modification Example 2 of the present disclosure.
[FIG. 9] FIG. 9 is a diagram illustrating an example of a cross-sectional configuration of an imaging device according to Modification Example 3 of the present disclosure.
[FIG. 10A] FIG. 10A is an explanatory diagram of an example of a manufacturing method of the imaging device according to Modification Example 3 of the present disclosure.
[FIG. 10B] FIG. 10B is an explanatory diagram of an example of the manufacturing method of the imaging device according to Modification Example 3 of the present disclosure.
[FIG. 10C] FIG. 10C is an explanatory diagram of an example of the manufacturing method of the imaging device according to Modification Example 3 of the present disclosure.
[FIG. 10D] FIG. 10D is an explanatory diagram of an example of the manufacturing method of the imaging device according to Modification Example 3 of the present disclosure.
[FIG. 10E] FIG. 10E is an explanatory diagram of an example of the manufacturing method of the imaging device according to Modification Example 3 of the present disclosure.
[FIG. 10F] FIG. 10F is an explanatory diagram of an example of the manufacturing method of the imaging device according to Modification Example 3 of the present disclosure.
[FIG. 11] FIG. 11 is a diagram illustrating another example of the cross-sectional configuration of the imaging device according to Modification Example 3 of the present disclosure.
[FIG. 12] FIG. 12 is a diagram illustrating another example of the cross-sectional configuration of the imaging device according to Modification Example 3 of the present disclosure.
[FIG. 13] FIG. 13 is a diagram illustrating another example of the cross-sectional configuration of the imaging device according to Modification Example 3 of the present disclosure.
[FIG. 14] FIG. 14 is a diagram illustrating an example of a cross-sectional configuration of an imaging device according to Modification Example 4 of the present disclosure.
[FIG. 15] FIG. 15 is a diagram illustrating another example of the cross-sectional configuration of the imaging device according to Modification Example 4 of the present disclosure.

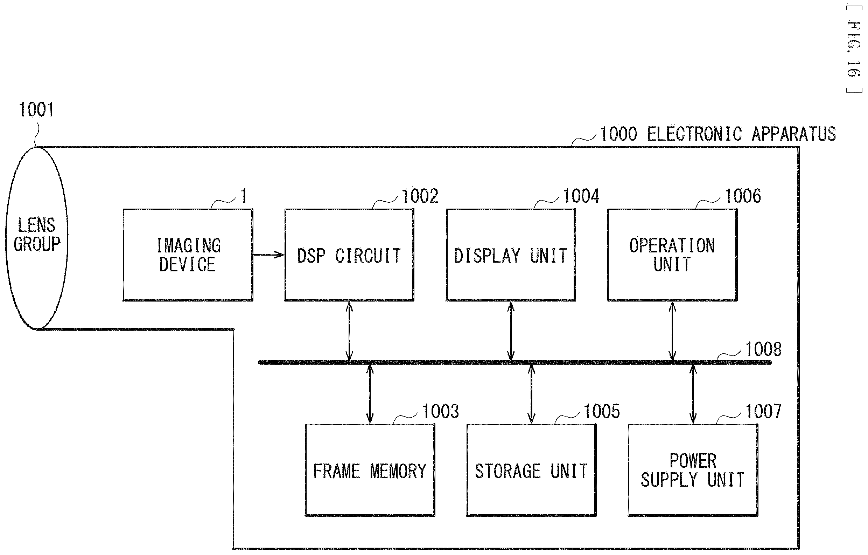

[FIG. 16] FIG. 16 is a block diagram illustrating a configuration example of an electronic apparatus including the imaging device.

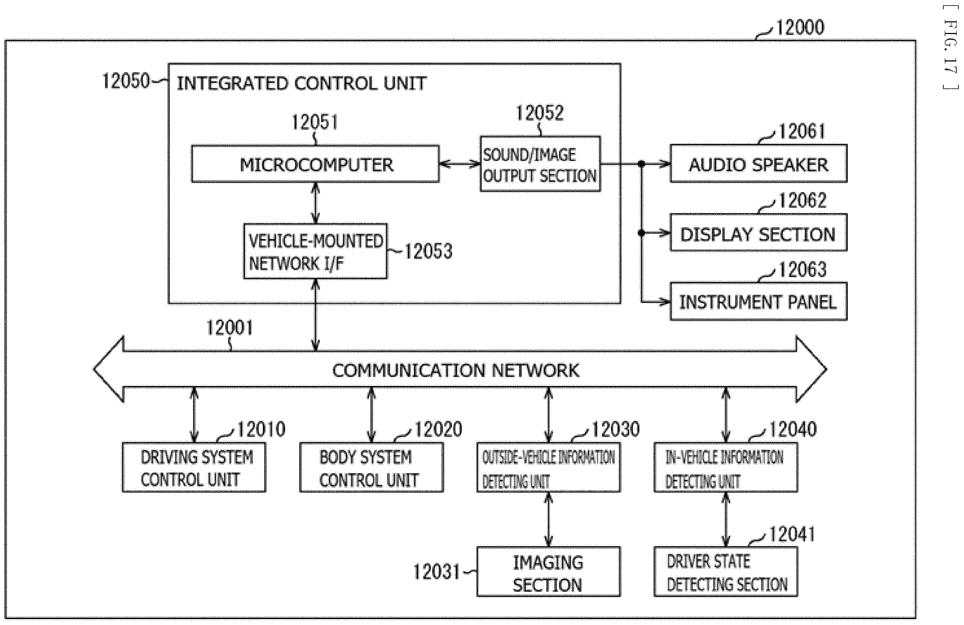

[FIG. 17] FIG. 17 is a block diagram depicting an example of schematic configuration of a vehicle control system.

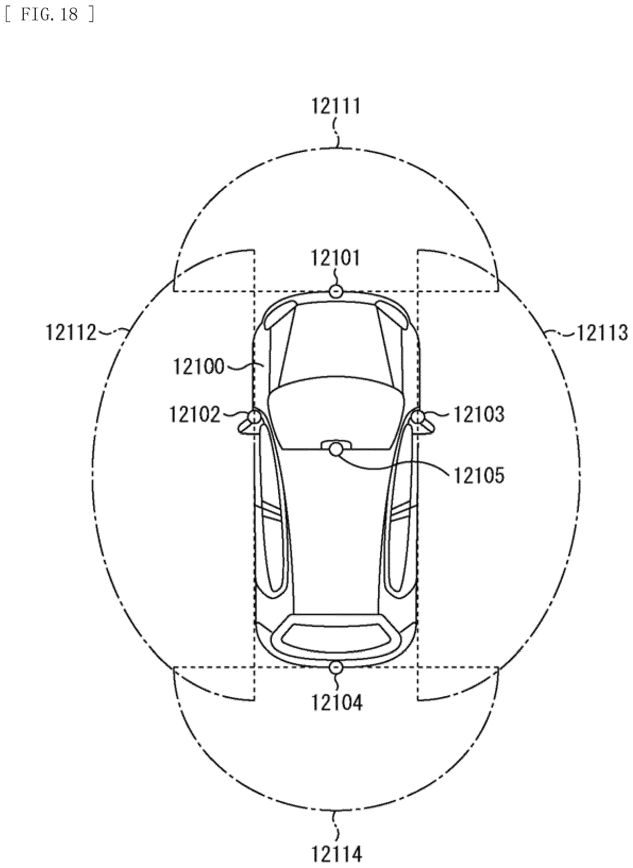

[FIG. 18] FIG. 18 is a diagram of assistance in explaining an example of installation positions of an outside-vehicle information detecting section and an imaging section.

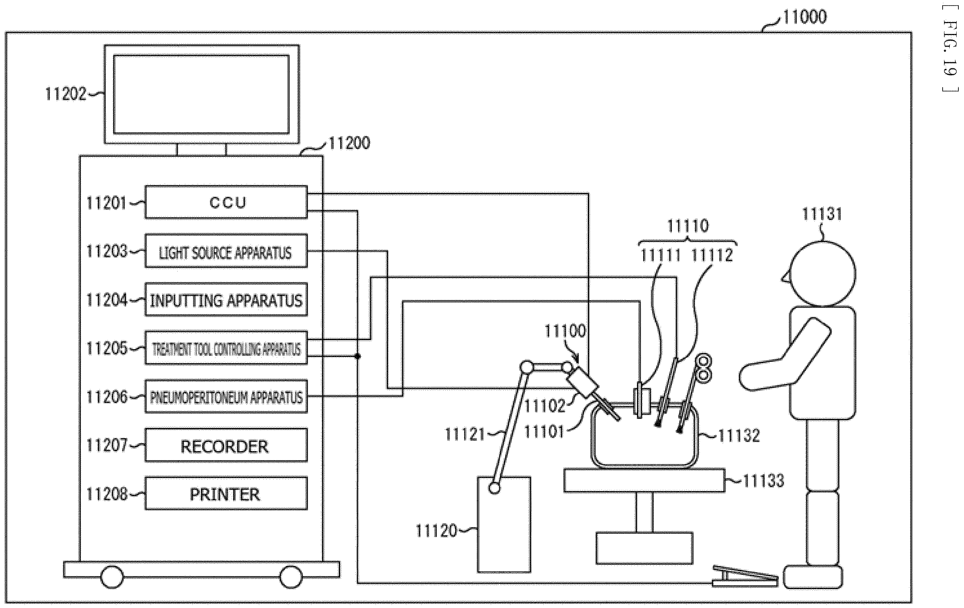

[FIG. 19] FIG. 19 is a view depicting an example of a schematic configuration of an endoscopic surgery system.

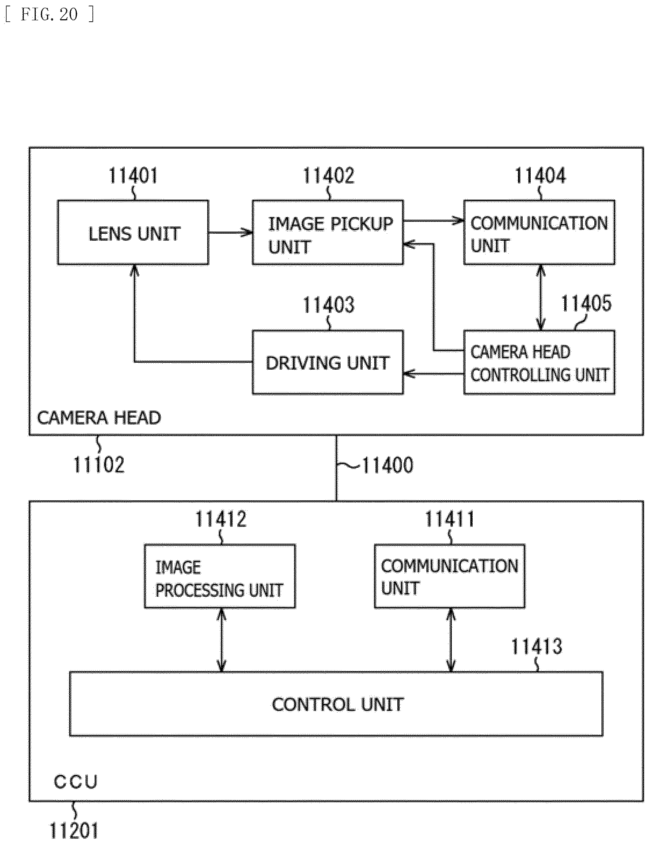

[FIG. 20] FIG. 20 is a block diagram depicting an example of a functional configuration of a camera head and a camera control unit (CCU).

### Modes for Carrying Out the Invention

Hereinafter, description is given in detail of embodiments of the present disclosure with reference to the drawings. It is to be noted that the description is given in the following order.
1. Embodiment
2. Modification Examples
3. Application Example
4. Practical Application Examples

### <1. Embodiment>

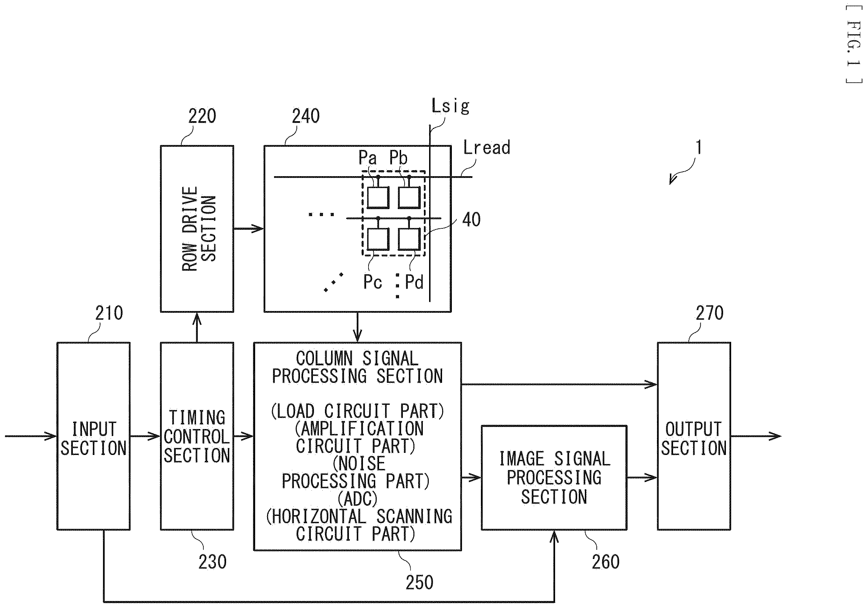

FIG. 1 is a block diagram illustrating an example of an overall configuration of an imaging device, which is an example of a light-receiving device according to an embodiment of the present disclosure. An imaging device 1 which is the light-receiving device is a device that receives incident light to perform photoelectric conversion. The imaging device (light-receiving device) 1 photoelectrically converts the received light to generate a signal. The imaging device 1 takes in incident light (image light) from a subject via an optical lens system (unillustrated). The imaging device 1 is, for example, a CMOS (Complementary Metal Oxide Semiconductor) image sensor, and captures an image of the subject.

The imaging device 1 includes a pixel array section 240 in which pixels P each including a photoelectric conversion section (photoelectric conversion element) are arranged in matrix. In the pixel array section 240, the pixels P each including the photoelectric conversion section are arranged in matrix. The pixel array section 240 is a region in which the pixels P are repeatedly arranged in an array. The imaging device 1 includes, in a peripheral region of the pixel array section 240, for example, an input section 210, a row drive section 220, a timing control section 230, a column signal processing section 250, an image signal processing section 260, and an output section 270.

In the present embodiment, pixel sharing units 40 each including a plurality of pixels P are arranged in an array. In the example illustrated in FIG. 1, the pixel sharing unit 40 includes four pixels (a pixel Pa, a pixel Pb, a pixel Pc, and a pixel Pd). The pixels Pa to Pd are arranged in two rows × two columns, for example. Each of the pixels Pa to Pd has, for example, a photodiode PD as the photoelectric conversion section.

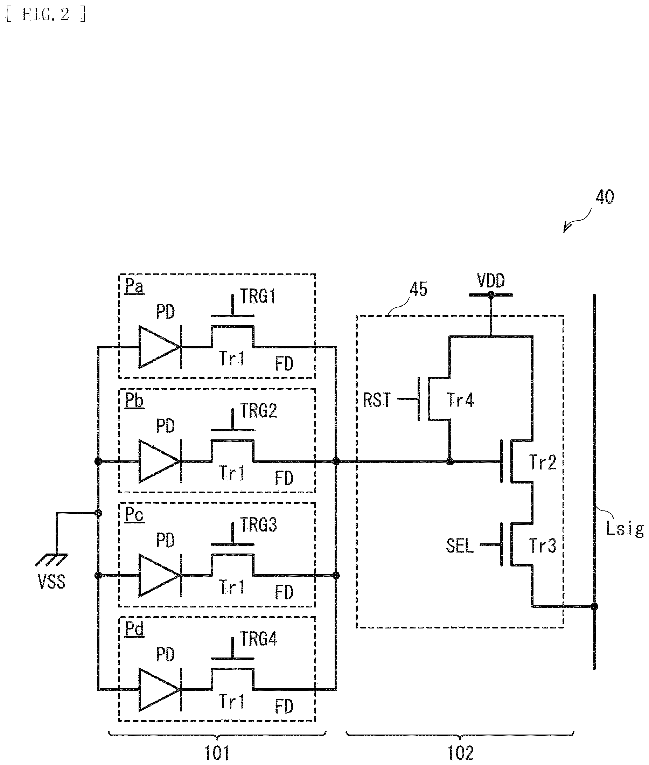

The imaging device 1 is provided with a readout circuit (see FIG. 2) described later for each of the pixel sharing units 40. The readout circuit includes an amplification transistor, a reset transistor, and the like, and outputs a pixel signal based on electric charge photoelectrically converted by the photoelectric conversion section. The pixel sharing unit 40 is a unit that shares one readout circuit, and the plurality of pixels (pixels Pa to Pd in FIG. 1) of the pixel sharing unit 40 shares one readout circuit. In the pixel array section 240, one readout circuit is provided for every four pixels (pixels Pa to Pd). Operating the readout circuit time-divisionally allows respective pixel signals of the pixels Pa to Pd to be read.

As illustrated in FIG. 1, the imaging device 1 is provided with a plurality of row drive signal lines Lread (row selection lines, reset control lines, etc.) and a plurality of vertical signal lines (column read lines) Lsig. For example, in the pixel array section 240, the row drive signal lines Lread are wired for respective pixel rows configured by the plurality of pixels P arranged in a horizontal direction (row direction). In addition, in the pixel array section 240, the vertical signal lines Lsig are wired for respective pixel columns configured by the plurality of pixels P arranged in a vertical direction (column direction). The row drive signal line Lread transmits a signal that drives each transistor of the pixel sharing unit 40, for example. A pixel signal may be read from each of the pixels Pa to Pd included in the pixel sharing unit 40 to the vertical signal line Lsig.

The row drive section 220 is configured by a plurality of circuits each including a shift register, an address decoder, and the like. The row drive section 220 (drive circuit) generates a signal to drive the pixel P, and outputs the signal to each of the pixel sharing units 40 of the pixel array section 240 via the row drive signal line Lread. The row drive section 220 generates, for example, a signal TRG that controls a transfer transistor, a signal SEL that controls a selection transistor, a signal RST that controls a reset transistor, and the like, and outputs the signals to each of the pixel sharing units 40 by the row drive signal line Lread.

As described above, the row drive signal line Lread transmits drive signals (signal TRG, signal SEL, etc.) to read signals from the pixels P. The row drive section 220 is a row address control section, selectively scans each of the pixels P of the pixel array section 240, and drives the plurality of pixels P arranged in the pixel array section 240, for example, on a row-by-row basis. The pixel signal of each of the pixels P selectively scanned by the row drive section 220 is outputted to the column signal processing section 250 via the vertical signal line Lsig coupled to the pixel P.

The column signal processing section 250 (signal processing circuit) includes, for example, a load circuit part coupled to the vertical signal line Lsig. The load circuit part constitutes a source follower circuit together with the amplification transistor of the readout circuit. It is to be noted that the column signal processing section 250 may include an amplification circuit part that amplifies a pixel signal read from the pixel sharing unit 40 via the vertical signal line Lsig. In addition, the column signal processing section 250 may include a noise processing part that removes a noise component from the pixel signal.

In addition, the column signal processing section 250 includes an analog-to-digital converter (ADC). The ADC includes, for example, a comparator part and a counter part. The comparator part compares an analog signal to be converted with a reference signal to be compared. The counter part measures time until inversion of a comparison result at the comparator part.

The ADC of the column signal processing section 250 converts a pixel signal as an analog signal to be outputted from the pixel sharing unit 40 into a digital signal. The ADC may perform AD conversion on a pixel signal before noise processing by the noise processing part, or may perform AD conversion on a pixel signal after the noise processing by the noise processing part. It is to be noted that the column signal processing section 250 may also include a horizontal scanning circuit part that performs a control to scan a read column.

The timing control section 230 supplies a signal that controls a timing to the row drive section 220 and the column signal processing section 250 on the basis of, for example, a reference clock signal and a timing control signal inputted to the imaging device 1 from the outside. The timing control signal is, for example, a vertical synchronization signal, a horizontal synchronization signal, or the like. The timing control section 230 (control circuit) includes, for example, a timing generator that generates various timing signals, and controls driving of the row drive section 220, the column signal processing section 250, and the like on the basis of the generated various timing signals.

The image signal processing section 260 is a circuit that performs various types of signal processing on the pixel signal. The image signal processing section 260 may include a processor and a memory. The image signal processing section 260 (signal processing circuit) performs, for example, signal processing such as tone curve correction processing for gradation adjustment and black level adjustment on a pixel signal subjected to the AD conversion. It is to be noted that characteristic data on a tone curve indicating a correction amount of gradation may be stored in advance in a memory inside the image signal processing section 260.

The input section 210 and the output section 270 exchange signals with the outside. For example, the above-described reference clock signal, timing control signal, and characteristic data are inputted to the input section 210 (input circuit) from the outside of the imaging device 1. The output section 270 (output circuit) may output to the outside, for example, a pixel signal after the signal processing by the image signal processing section 260 or a pixel signal before the signal processing by the image signal processing section 260.

FIG. 2 is a diagram illustrating a configuration example of the pixel sharing unit of the imaging device according to an embodiment of the present disclosure. Description is given below of an example of a case where four pixels P share one readout circuit 45, as illustrated in FIG. 1. Each of the four pixels Pa to Pd includes the photodiode PD, which is a photoelectric conversion section (photoelectric conversion element), a transfer transistor Tr1, and a floating diffusion FD.

The photodiode PD, which is a photoelectric conversion section, converts incident light into electric charge. The photodiode PD performs photoelectric conversion to generate electric charge corresponding to a received light amount. The transfer transistor Tr1 is electrically coupled to the photodiode PD. The transfer transistor Tr1 is controlled by the signal TRG, and is photoelectrically converted by the photodiode PD to transmit accumulated electric charge to the floating diffusion FD.

The floating diffusion FD is an accumulation section, and accumulates transferred electric charge. The floating diffusion FD can also be referred to as a holding section that holds electric charge transferred from the photodiode PD. The floating diffusion FD accumulates the transferred electric charge, and converts the electric charge into a voltage corresponding to a capacitance of the floating diffusion FD. The electric charge converted by the photodiode PD is transferred to the floating diffusion FD by the transfer transistor Tr1, and is converted into a voltage corresponding to the capacitance of the floating diffusion FD.

In the example illustrated in FIG. 2, the transfer transistors Tr1 of the respective pixels Pa to the pixel Pd are controlled ON/OFF by signals different from each other. The transfer transistor Tr1 of the pixel Pa is controlled by the signal TRG1, and the transfer transistor Tr1 of the pixel Pb is controlled by the signal TRG2. In addition, the transfer transistor Tr1 of the pixel Pc is controlled by the signal TRG3, and the transfer transistor Tr1 of the pixel Pd is controlled by the signal TRG4.

As an example, the readout circuit 45 includes an amplification transistor Tr2, a selection transistor Tr3, and a reset transistor Tr4. A gate of the amplification transistor Tr2 is coupled to the floating diffusion FD, and receives an input of a voltage converted by the floating diffusion FD. The amplification transistor Tr2 generates a pixel signal based on a voltage of the floating diffusion FD. The pixel signal is an analog signal based on photoelectrically converted electric charge.

The selection transistor Tr3 is controlled by the signal SEL, and outputs a pixel signal from the amplification transistor Tr2 to the vertical signal line Lsig. The selection transistor Tr3 can also be said to control an output timing of the pixel signal. The reset transistor Tr4 may be controlled by the signal RST to reset the electric charge accumulated in the floating diffusion FD and to reset the voltage of the floating diffusion FD. A pixel signal outputted from the readout circuit 45 is inputted to the above-described column signal processing section 250 (see FIG. 1) via the vertical signal line Lsig. It is to be noted that the selection transistor Tr3 may be provided between a power supply line to be supplied with a power supply voltage VDD and the amplification transistor Tr2. In addition, the selection transistor Tr3 may be omitted as needed.

The readout circuit 45 may include a transistor (gain switching transistor) to change a gain of electric charge-voltage conversion in the floating diffusion FD. The gain switching transistor is provided between the reset transistor Tr4 and the floating diffusion FD, for example. Bringing the gain switching transistor into an ON state increases a capacitance to be added to the floating diffusion FD, thus making it possible to change the gain upon conversion of electric charge into a voltage.

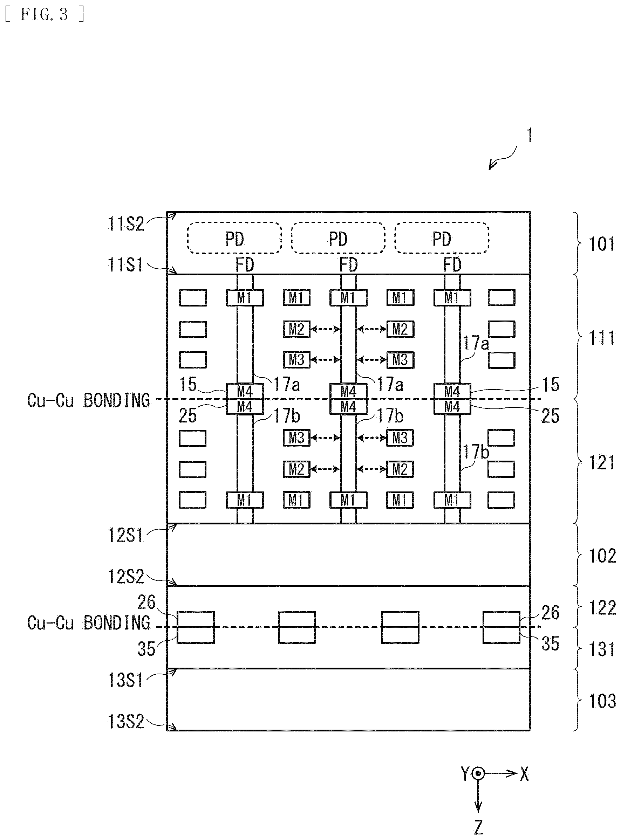

FIG. 3 is a schematic view of an example of a cross-sectional configuration of the imaging device according to an embodiment of the present disclosure. The imaging device 1 has a configuration in which a first substrate 101, a second substrate 102, and a third substrate 103 are stacked in a Z-axis direction. The first substrate 101, the second substrate 102, and the third substrate 103 are each configured by a semiconductor substrate (e.g., silicon substrate). It is to be noted that, as illustrated in FIG. 3, a direction of incidence of light from a subject is defined as the Z-axis direction, a right-left direction on the sheet orthogonal to the Z-axis direction is defined as an X-axis direction, and a direction orthogonal to the Z-axis direction and the X-axis direction is defined as a Y-axis direction. In the following diagrams, a direction may be expressed, in some cases, with arrows in FIG. 3 as references.

As illustrated in FIG. 3, the first substrate 101, the second substrate 102, and the third substrate 103 have, respectively, first surfaces 11S1, 12S1, and 13S1 to be provided with transistors, and second surfaces 11S2, 12S2, and 13S2. The first surfaces 11S1, 12S1, and 13S1 are each an element formation surface on which an element such as a transistor is formed. The first surfaces 11S1, 12S1, and 13S1 are each provided with a gate electrode, a gated oxide film, or the like.

The first surface 11S1 of the first substrate 101 is provided with a wiring layer 111, as illustrated in FIG. 3. The first surface 12S1 of the second substrate 102 is provided with a wiring layer 121, and the second surface 12S2 of the second substrate 102 is provided with a wiring layer 122. In addition, the first surface 13S1 of the third substrate 103 is provided with a wiring layer 131. The wiring layers 111, 121, 122, and 131 include, for example, a conductive film and an insulating film, and include a plurality of wiring lines, vias, or the like. Each of the wiring layers 111, 121, 122, and 131 includes, for example, wiring lines of two or more layers. The wiring layers 111, 121, 122, and 131 may each include wiring lines of three layers or four or more layers.

The wiring layers 111, 121, 122, and 131 have a configuration in which, for example, the wiring lines are stacked with an interlayer insulating layer (interlayer insulating film) interposed therebetween. The wiring layer is formed using, for example, aluminum (Al), copper (Cu), tungsten (W), polysilicon (Poly-Si), or the like. The interlayer insulating layer is formed by a monolayer film including one of silicon oxide (SiO), silicon nitride (SiN), or silicon oxynitride (SiON), for example, or a stacked film including two or more thereof.

It is to be noted that the first substrate 101 and the wiring layer 111 can also be collectively referred to as the first substrate 101 (or a first circuit layer). In addition, the second substrate 102 and the wiring layers 121 and 122 can also be collectively referred to as the second substrate 102 (or a second circuit layer). Further, the third substrate 103 and the wiring layer 131 can also be collectively referred to as the third substrate 103 (or a third circuit layer).

The first substrate 101 and the second substrate 102 are stacked by bonding between electrodes to allow the first surface 11S1 and the first surface 12S1 on each of which elements such as transistors are formed to be opposed to each other. That is, the first substrate 101 and the second substrate 102 are bonded to each other to allow their respective front surfaces to be opposed to each other. This bonding method is referred to as Face to Face bonding.

The second substrate 102 and the third substrate 103 are stacked d by bonding between electrodes to allow the second surface 12S2 and the first surface 13S1 on which elements such as transistors are formed to be opposed to each other. That is, the second substrate 102 and the third substrate 103 are bonded to each other to allow a back surface of the second substrate 102 and a front surface of the third substrate 103 to be opposed to each other. This bonding method is referred to as Face to Back bonding.

As an example, the first surface 11S1 of the first substrate 101 and the first surface 12S1 of the second substrate 102 are attached to each other by bonding between metal electrodes including copper (Cu), i.e., Cu-Cu bonding. In addition, the second surface 12S2 of the second substrate 102 and the first surface 13S1 of the third substrate 103 are also attached to each other, for example by Cu-Cu bonding. It is to be noted that the electrode to be used for the bonding may be configured by a metal material other than copper (Cu), e.g., nickel (Ni), cobalt (Co), tin (Sn), or the like, or may be configured by another material.

In the example illustrated in FIG. 3, a plurality of electrodes 15 configured by a fourth layer wiring line M4 in the wiring layer 111 and a plurality of electrodes 25 configured by the fourth layer wiring line M4 in the wiring layer 121 are bonded to each other, to thereby allow the first substrate 101 and the second substrate 102 to be coupled to each other. In addition, a plurality of electrodes 26 configured by a wiring line of the uppermost layer in the wiring layer 122 and a plurality of electrodes 35 configured by a wiring line of the uppermost layer in the wiring layer 131 are bonded to each other, to thereby allow the second substrate 102 and the third substrate 103 to be coupled to each other. The electrodes 15, 25, 26, and 35 are each a bonding electrode.

In the imaging device 1 according to the present embodiment, the photodiode PD, the transfer transistor Tr1, and the floating diffusion FD described above are disposed in the first substrate 101, and the readout circuit 45 is disposed in the second substrate 102. The photodiode PD and the readout circuit 45 are disposed in separate substrates, thus making it possible to allow the photodiode PD to have a sufficient size, as compared with a case where the photodiode PD and the readout circuit 45 are disposed in the same substrate. This makes it possible to acquire an image having a wide dynamic range. It is to be noted that, in the third substrate 103, for example, there are disposed the above-described row drive section 220, the timing control section 230, the column signal processing section 250, the image signal processing section 260, and the like. In addition, the input section 210 and the output section 270 described above may be disposed in the third substrate 103.

As schematically illustrated in FIG. 3, the floating diffusion FD of the pixel P of the first substrate 101 is electrically coupled to the amplification transistor Tr2, or the like of the readout circuit 45 of the second substrate 102 via the wiring line of the wiring layer 111 and the wiring line of the wiring layer 121. Electric charge photoelectrically converted by the photodiode PD of the first substrate 101 is outputted to the floating diffusion FD and the readout circuit 45 of the second substrate 102 via the transfer transistor Tr1.

The imaging device 1 according to the present embodiment is provided with a through-via 17 that penetrates a plurality of layers. The through-via 17 is a via that penetrates some or all of layers in the wiring layer. For example, the through-via 17 penetrates some of the wiring lines and the interlayer insulating film in the wiring layer to couple the upper layer wiring line and the lower layer wiring line to each other. The through-via 17 is a coupling section, and may couple wiring lines to each other, which are distant from each other by two or more layers, for example. The imaging device 1 is provided with the through-via 17 for each of the pixels P or for every plurality of pixels P.

The through-via 17 is configured by, for example, tungsten (W), aluminum (Al), cobalt (Co), molybdenum (Mo), ruthenium (Ru), or the like. It is to be noted that the through-via 17 may be formed by another metal material. FIG. 3 exemplifies, as the through-via 17, a first through-via 17a and a second through-via 17b. The first through-via 17a and the second through-via 17b may be collectively referred to herein as the through-via 17 in some cases.

As schematically illustrated in FIG. 3, the wiring layers 111 and 121 include the first through-via 17a and the second through-via 17b, respectively. A plurality of first through-vias 17a is provided in the wiring layer 111, and a plurality of second through-vias 17b is provided in the wiring layer 121. The first through-via 17a and the second through-via 17b are provided for each of the readout circuits 45, for example.

The first through-via 17a is a via that penetrates a plurality of layers in the wiring layer 111. In the example illustrated in FIG. 3, the first through-via 17a is provided to penetrate layers of a second layer wiring line and a third layer wiring line among layers of first to fourth wiring lines of the wiring layer 111. The first through-via 17a coupled to a first layer wiring line M1 of the wiring layer 111 is formed to extend in the Z-axis direction to reach the fourth layer wiring line M4. That is, the first through-via 17a couples the first layer wiring line M1 and the fourth layer wiring line M4 to each other in the wiring layer 111 without passing through a second layer wiring line M2 and a third layer wiring line M3.

The second through-via 17b is a via that penetrates a plurality of layers in the wiring layer 121. In the example illustrated in FIG. 3, the second through-via 17b is provided to penetrate layers of a second layer wiring line and a third layer wiring line among layers of first to fourth wiring lines of the wiring layer 121. The second through-via 17b couples the first layer wiring line M1 and the fourth layer wiring line M4 to each other in the wiring layer 121 without passing through the second layer wiring line M2 and the third layer wiring line M3. It is to be noted that first through-via 17a and the second through-via 17b may each be provided to penetrate layers of wiring lines of three or more layers.

In the present embodiment, the floating diffusion FD provided in the first substrate 101 is electrically coupled to the readout circuit 45 of the second substrate 102 via the first through-via 17a, the bonding electrodes 15 and 25, and the second through-via 17b. The first through-via 17a is coupled to the electrode 15 without passing through some of the plurality of layers (layers of the second and third layer wiring lines in FIG. 3) in the wiring layer 111. It is therefore possible, in the wiring layer 111, to widen (lengthen) each of an interval (distance) between the first through-via 17a and the second layer wiring line M2 and an interval between the first through-via 17a and the third layer wiring line M3, as indicated by dotted arrows in FIG. 3. It is therefore possible to reduce a wiring capacitance to be added to the floating diffusion FD electrically coupled to the first through-via 17a.

In addition, the second through-via 17b is coupled to the electrode 25 without passing through some of the plurality of layers (layers of the second and third layer wiring lines in FIG. 3) in the wiring layer 121. It is therefore possible, in the wiring layer 121, to widen each of an interval between the second through-via 17b and the second layer wiring line M2 and an interval between the second through-via 17b and the third layer wiring line M3, as indicated by dotted arrows in FIG. 3. It is therefore possible to reduce a wiring capacitance to be added to the floating diffusion FD electrically coupled to the second through-via 17b.

As described above, in the present embodiment, the interval between the wiring line coupling the floating diffusion FD and the readout circuit 45 to each other and the surrounding metal wiring line is secured. This makes it possible to reduce a capacitance to be added to the floating diffusion FD. It is therefore possible to improve conversion efficiency (conversion gain) upon conversion of electric charge into a voltage in the floating diffusion FD.

It becomes possible to suppress dispersion of wiring capacitances to be added to the floating diffusion FD, as compared with a case where the floating diffusion FD and the readout circuit 45 are coupled by a large number of wiring lines (e.g., eight-layer wiring lines). This makes it possible to reduce the dispersion of the conversion efficiencies, and thus to suppress degradation of the pixel signal.

It is to be noted that the imaging device 1 may include the through-via 17 electrically coupled to another circuit element of the first substrate 101, e.g., a gate of the transfer transistor Tr1 to transmit the signal TRG. In addition, the imaging device 1 may include the through-via 17 electrically coupled to another circuit element of the second substrate 102, e.g., a gate of the selection transistor Tr3 or a gate of the reset transistor Tr4.

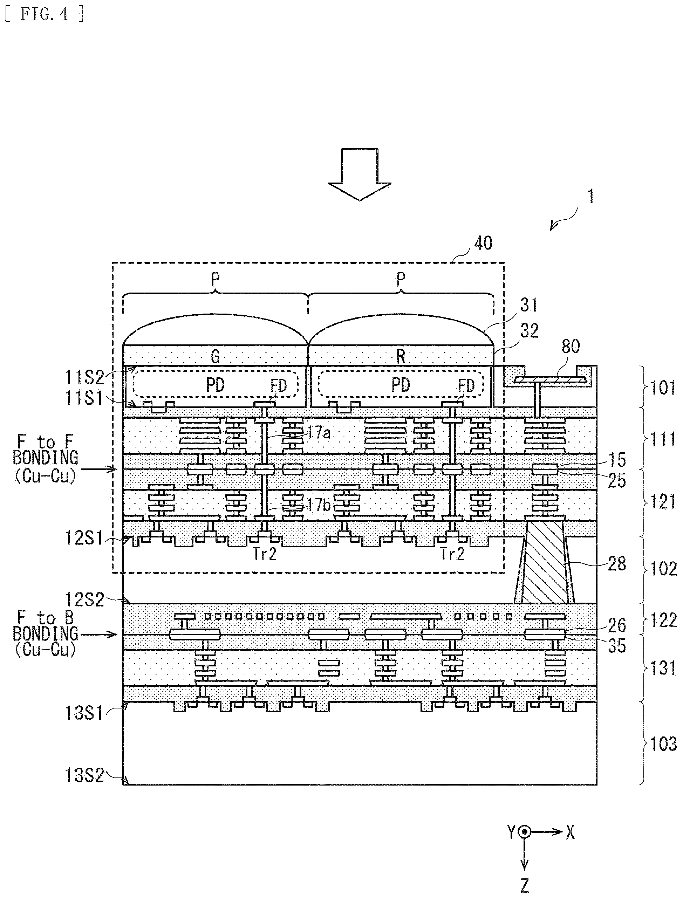

FIG. 4 is a diagram illustrating an example of a cross-sectional configuration of the imaging device according to an embodiment of the present disclosure. The imaging device 1 includes a lens section 31 that condenses light, and a color filter 32. The color filter 32 and the lens section 31 are sequentially stacked on the first substrate 101. The color filter 32 and the lens section 31 are provided for each of the pixels P, for example.

The lens section 31 guides light incident from above to a side of the photodiode PD in FIG. 4. The lens section 31 is an optical member also referred to as an on-chip lens. The color filter 32 selectively transmits light of a specific wavelength region of incident light. Light transmitted through the lens section 31 and the color filter 32 is incident on the photodiode PD. The photodiode PD photoelectrically converts the incident light to generate electric charge.

In the example illustrated in FIG. 4, a pad 80 is provided on a side of the second surface 11S2 of the first substrate 101. In the first substrate 101, an opening on the pad 80 is formed, and the pad 80 is exposed to the outside. The pad 80 is, for example, an electrode formed using aluminum (Al). It is to be noted that pad 80 may be configured using another metal material. A plurality of pads 80 is disposed in the imaging device 1. The pad 80 may supply, for example, the power supply voltage VDD (or a ground voltage VSS) inputted from the outside to respective circuits of the first substrate 101 to the third substrate 103.

In addition, the imaging device 1 is provided with a through-electrode 28, as illustrated in FIG. 4. The through-electrode 28 is an electrode that penetrates the second substrate 102. The through-electrode 28 extends in the Z-axis direction, and is formed to reach the wiring layer 122 of the second substrate 102. The through-electrode 28 is able to couple a circuit provided on a side of the first surface 12S1 of the second substrate 102 and a circuit provided on a side of the second surface 12S2 of the second substrate 102 to each other. The through-electrode 28 couples circuits provided in different layers to each other. The through-electrode 28 is configured by, for example, tungsten (W), aluminum (Al), cobalt (Co), molybdenum (Mo), ruthenium (Ru), or the like. It is to be noted that the through-electrode 28 may be formed by another metal material.

For example, a plurality of through-electrodes 28 is disposed in the peripheral region of the pixel array section 240. The readout circuit 45 provided in the second substrate 102 is electrically coupled to circuits of the third substrate 103 and the wiring layer 131 via the wiring layer 121, the through-electrode 28, and the wiring layer 122. The readout circuit 45 is electrically coupled by the plurality of through-electrodes 28 to, for example, a circuit that controls the readout circuit 45 and a circuit that processes a pixel signal outputted from the readout circuit 45. For example, the readout circuit 45 is coupled to the row drive section 220 and the column signal processing section 250 described above via the through-electrodes 28 different from each other.

The plurality of through-electrodes 28 provided in the imaging device 1 includes, for example, a through-electrode, or the like, that transmits a pixel signal and signals (the signal SEL, the signal RST, etc. described above) to control the transistors of the readout circuit 45. In addition, the through-electrode 28 coupled to a power supply line to supply the power supply voltage VDD, the through-electrode 28 coupled to a grounding wire to supply the ground voltage VSS, or the like may be disposed.

As illustrated in FIG. 4, the floating diffusion FD and the amplification transistor Tr2, or the like of the readout circuit 45 are electrically coupled to each other via the first through-via 17a and the second through-via 17b. Electric charge photoelectrically converted in the photodiode PD is transferred by the transfer transistor Tr1 to the floating diffusion FD, the first through-via 17a, and the second through-via 17b. The amplification transistor Tr2 generates a pixel signal corresponding to a voltage having been subjected to electric charge-voltage conversion in the floating diffusion FD. Pixel signals outputted by the amplification transistor Tr2 and the selection transistor Tr3 of the readout circuit 45 are transmitted to the column signal processing section 250 of the third substrate 103, for example.

In the example illustrated in FIG. 4, the color filter 32 that transmits green (G) light is provided on the photodiode PD of the pixel P on the left side of the right and left pixels P in the pixel sharing unit 40. The photodiode PD of the pixel P on the left side receives light of a green wavelength region to perform photoelectric conversion. The color filter 32 that transmits red (R) light is provided on the photodiode PD of the pixel P on the right side of the right and left pixels P in the pixel sharing unit 40. The photodiode PD of the pixel P on the right side receives light of a red wavelength region to perform photoelectric conversion. It is to be noted that the photodiode PD disposed below the color filter 32 that transmits blue (B) light receives light of a blue wavelength region to perform photoelectric conversion. It is therefore possible for the respective pixels P of the imaging device 1 to generate a pixel signal of an R component, a pixel signal of a G component, and a pixel signal of a B component. It becomes possible for the imaging device 1 to obtain pixel signals of RGB.

It is to be noted that the color filter 32 is not limited to the color filter of the primary color system (RGB) but may be a color filter of a complementary color system such as Cy (cyan), Mg (magenta), or Ye (yellow). In addition, a color filter corresponding to W (white), i.e., a filter that transmits light of all wavelength regions of incident light may be disposed.

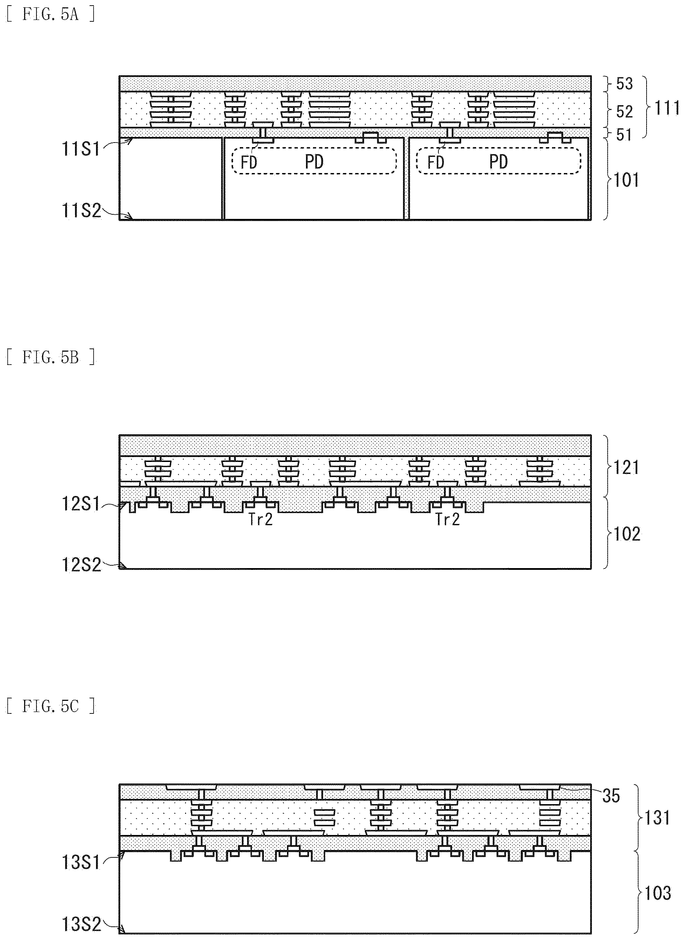

FIGs. 5A to 5G are each a diagram illustrating an example of a manufacturing method of the imaging device according to an embodiment of the present disclosure. First, as illustrated in FIG. 5A, various elements such as the photodiode PD and the transfer transistor Tr1 are formed in the first substrate 101. The transfer transistor Tr1, the floating diffusion FD, and the like are provided on a side of the first surface 11S1 of the first substrate 101. In addition, the wiring layer 111 is formed on the first surface 11S1 of the first substrate 101.

In this case, for example, an insulating film such as a silicone oxide film (SiO₂) is formed as an interlayer insulating layer (interlayer insulating film) in each of a lower layer part 51 and an upper layer part 53 of the wiring layer 111. In a middle layer part 52 of the wiring layer 111, for example, an insulating film having a permittivity lower than that of the silicone oxide film is formed as an interlayer insulating layer in order to reduce the wiring capacitance. The interlayer insulating layer of the middle layer part 52 may be configured by SiOC, SiOCH, or the like which is a low permittivity material (Low-k material). The interlayer insulating layer of the middle layer part 52 may be configured by a silicone oxide film. The middle layer part 52 is provided with a wiring line configured by a conductor, e.g., a wiring line configured by copper (Cu) and tantalum (Ta) which is a barrier metal. It is to be noted that other wiring layers (wiring layers 121, 122, 131, etc.) may also be formed by stacking layers (e.g., the upper layer part and the lower layer part) including a silicon oxide film as the interlayer insulating layer and a layer (e.g., the middle layer part) including a low permittivity material as the interlayer insulating layer, in the same manner as the case of the wiring layer 111.

Various elements including the transistors of the readout circuit 45 are formed in the second substrate 102 illustrated in FIG. 5B. The amplification transistor Tr2, the selection transistor Tr3, the reset transistor Tr4, and the like are provided on the side of the first surface 12S1 of the second substrate 102. In addition, the wiring layer 121 is formed on the first surface 12S1 of the second substrate 102.

Various elements constituting the row drive section 220, the column signal processing section 250, the image signal processing section 260, and the like described above are formed in the third substrate 103 illustrated in FIG. 5C. For example, a transistor of the row drive section 220, a transistor of the column signal processing section 250, a transistor of the image signal processing section 260, and the like are provided on a side of the first surface 13S1 of the third substrate 103. In addition, the wiring layer 131 including the electrode 35 that serves as a terminal for Cu-Cu coupling is formed on the first surface 13S1 of the third substrate 103.

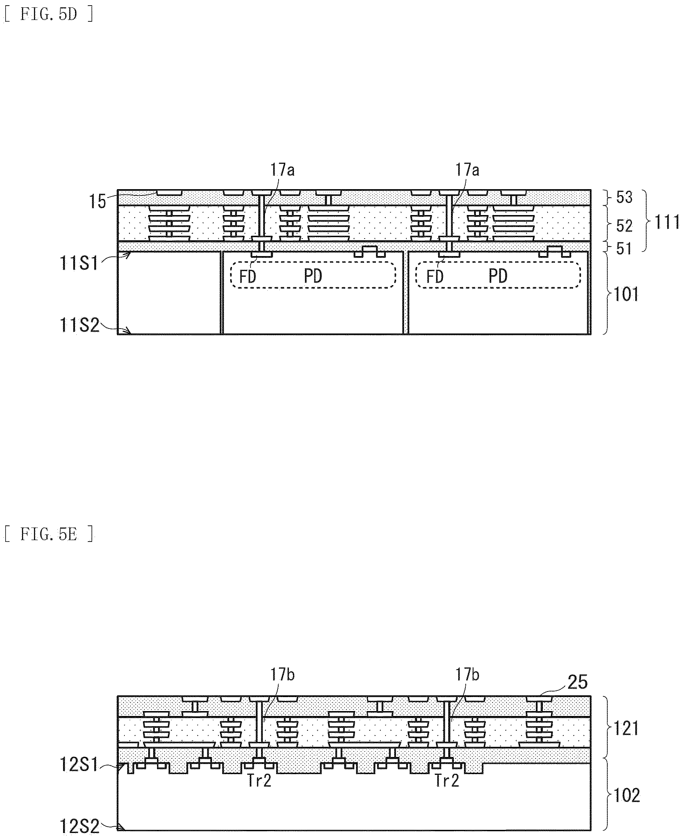

As illustrated in FIG. 5D, the plurality of first through-vias 17a, the electrode 15 that serve as a terminal for Cu-Cu coupling, and the like are formed in the wiring layer 111. The electrode 15 is disposed on a surface of the wiring layer 111. In addition, as illustrated in FIG. 5E, the plurality of second through-vias 17b, the electrode 25 that serve as a terminal for Cu-Cu coupling, and the like are formed in the wiring layer 121. The electrode 25 is disposed on a surface of the wiring layer 121.

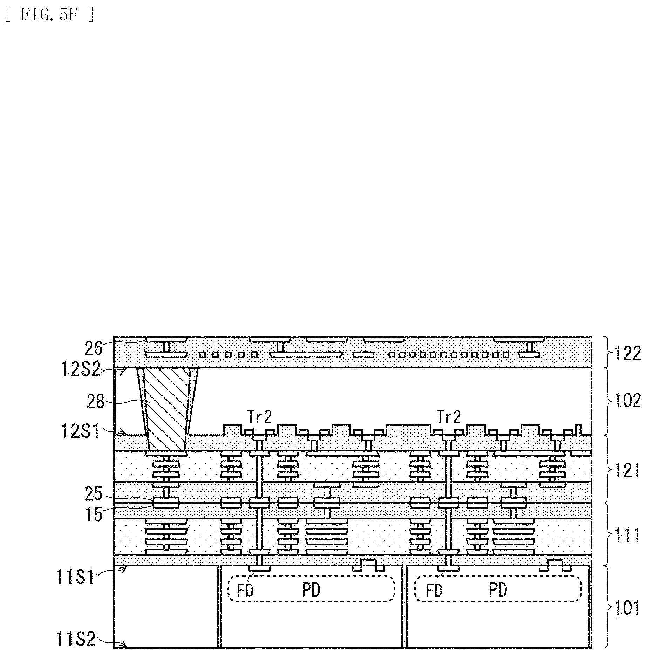

Next, as illustrated in FIG. 5F, the first substrate 101 and the second substrate 102 are Cu-Cu bonded by the plurality of electrodes 15 and the plurality of electrodes 25 to allow the first surface 11S1 and the first surface 12S1 to be opposed to each other. That is, respective surfaces of the first substrate 101 and the second substrate 102 are bonded to each other. Thereafter, a thickness of the second substrate 102 is reduced. As an example, the thickness of the second substrate 102 is set to 3 µm or less, e.g., 0.5 µm.

Next, an insulating film (e.g., silicon oxide film) is first formed on the second surface 12S2 of the second substrate 102, and then the insulating film and the second substrate 102 are partially etched (e.g., reactive ion etching) to form a hole for the through-electrode. It is to be noted that the hole for through-electrode may be formed in advance in the second substrate 102 and the wiring layer 121 before bonding the first substrate 101 and the second substrate 102 to each other. Then, an insulating film (e.g., silicone oxide film) is formed on an inner wall of the hole for the through-electrode. Further, etching is performed to allow a bottom surface of the hole for the through-electrode to reach the wiring layer 121, and the first layer wiring line M1 of the wiring layer 121 is exposed by the hole for the through-electrode.

Thereafter, a low-resistance electrically-conductive material including Cu or Al is used to fill the hole for the through-electrode, thus forming the through-electrode 28. Them, an extra metal film at the upper part of the through-electrode 28 is removed by CMP or etching. Further, the wiring layer 122 including a wiring line to be coupled to the through-electrode 28 and the electrode 26 that serves as a terminal for Cu-Cu coupling is formed on the side of the second surface 12S2 of the second substrate 102; this state is illustrated in FIG. 5F.

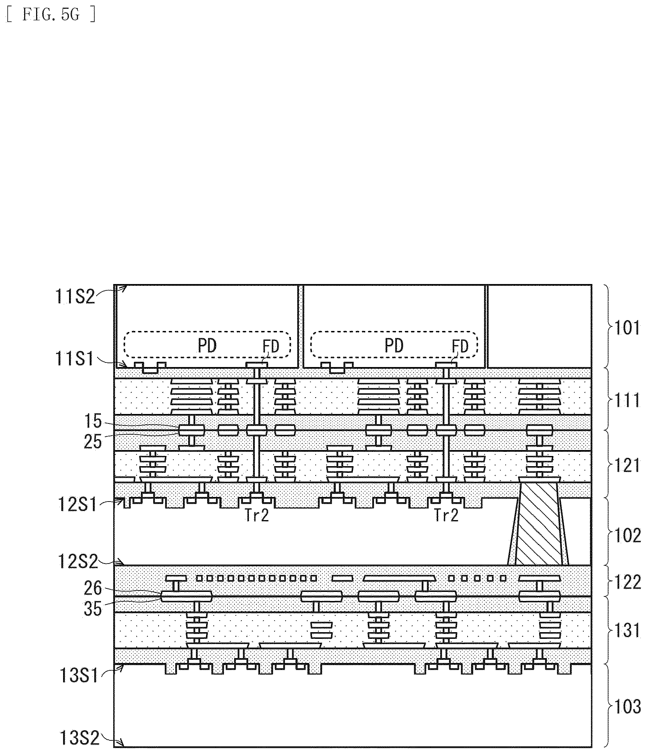

Next, as illustrated in FIG. 5G, the second substrate 102 and the third substrate 103 are then Cu-Cu bonded by the plurality of electrodes 26 and the plurality of electrodes 35 to allow the second surface 12S2 and the first surface 13S1 to be opposed to each other. Thereafter, a thickness of the first substrate 101 is reduced. As an example, the thickness of the first substrate 101 is set to 4 µm. Thereafter, the color filter 32 and the lens section 31 are sequentially formed on the side of the second surface 11S2 of the first substrate 101. Further, an opening is formed by dry etching in the peripheral region of the pixel array section 240, of a region on the side of the second surface 11S2 of the first substrate 101, and the pad 80 is provided. The above-described manufacturing method enables the imaging device 1 illustrated in FIG. 4 to be manufactured. In addition, it is to be noted that the above-described manufacturing method is merely exemplary and another manufacturing method may be adopted.

### [Workings and Effects]

The light-receiving device (the imaging device 1) according to the present embodiment includes: the first substrate 101 including a plurality of photoelectric conversion sections (the photodiodes PD) that photoelectrically converts light and an accumulation section (the floating diffusion FD) that accumulates electric charge photoelectrically converted by the photoelectric conversion sections; the second substrate 102 stacked on the first substrate and including the readout circuit 45 that outputs a first signal (the pixel signal) based on electric charge accumulated in the accumulation section; and a wiring layer (the wiring layers 111 and 121) including a via (the through-via 17) that electrically couples the accumulation section and the readout circuit to each other. The first substrate and the second substrate are stacked to allow a first surface of the first substrate (the first surface 11S1 of the first substrate 101) on which an element is formed and a second surface of the second substrate (the first surface 12S1 of the second substrate 102) on which an element is formed to be opposed to each other. The via (the through-via 17) penetrates a plurality of layers in the wiring layer.

In the imaging device 1 according to the present embodiment, the floating diffusion FD and the readout circuit 45 are electrically coupled to each other by the through-via 17 that penetrates a plurality of layers in the wiring layers 111 and 121. It is therefore possible to reduce a capacitance to be added to the floating diffusion FD. It becomes possible to improve the conversion efficiency (conversion gain) upon conversion of electric charge into a voltage in the floating diffusion FD.

Next, description is given of modification examples of the present disclosure. Hereinafter, components similar to those of the foregoing embodiment are denoted by the same reference numerals, and description thereof are omitted as appropriate.

### <2. Modification Examples>

### (2-1. Modification Example 1)

The description has been given, in the foregoing embodiment, of the example in which the through-via 17 is provided that couples wiring lines of different layers in the wiring layer. However, the through-via 17 may be directly coupled to the semiconductor substrate (e.g., the first substrate 101 or the second substrate 102). The first through-via 17a to be directly coupled to the circuit element (e.g., the floating diffusion FD, the transfer transistor Tr1, etc.) of the first substrate 101 may be provided. In addition, the second through-via 17b to be directly coupled to the circuit element (e.g., a transistor of the readout circuit 45) of the second substrate 102 may be provided.

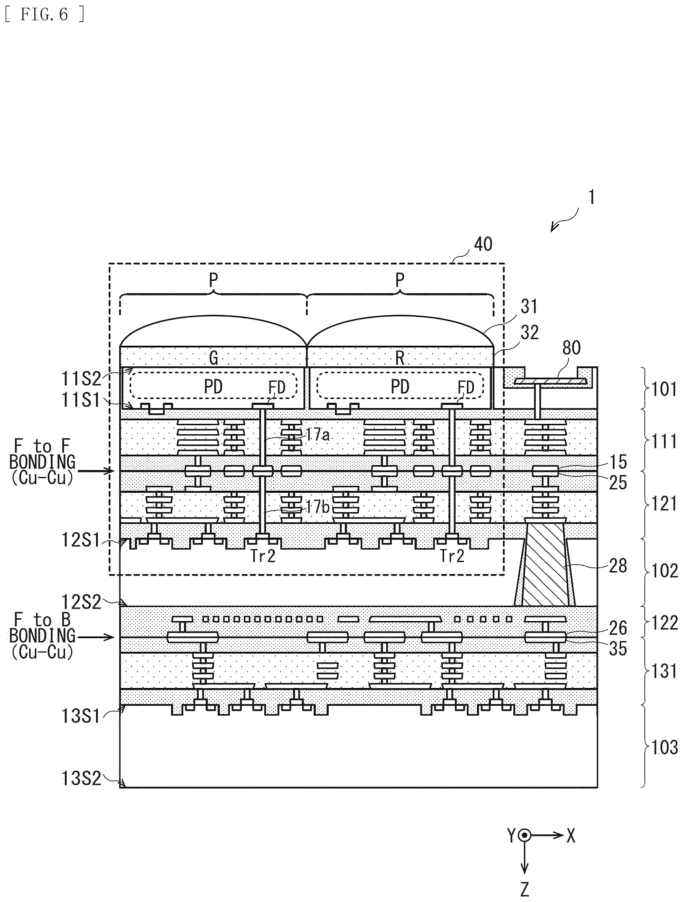

FIG. 6 is a diagram illustrating an example of a cross-sectional configuration of an imaging device according to Modification Example 1. The first through-via 17a is disposed that couples the bonding electrode 15 and the floating diffusion FD to each other. In the example illustrated in FIG. 6, the first through-via 17a is directly coupled to the floating diffusion FD as an accumulation section without passing through the first layer to fourth layer wiring lines in the wiring layer 111. In addition, the second through-via 17b is disposed that couples the coupling electrode 25 and the amplification transistor Tr2 of the readout circuit 45 to each other. In the example illustrated in FIG. 6, the second through-via 17b is directly coupled to the amplification transistor Tr2 without passing through the first layer to fourth layer wiring lines in the wiring layer 121. It is also possible, in the case of the present modification example, to reduce a capacitance to be added to the floating diffusion FD, and thus to improve the conversion efficiency.

### (2-2. Modification Example 2)

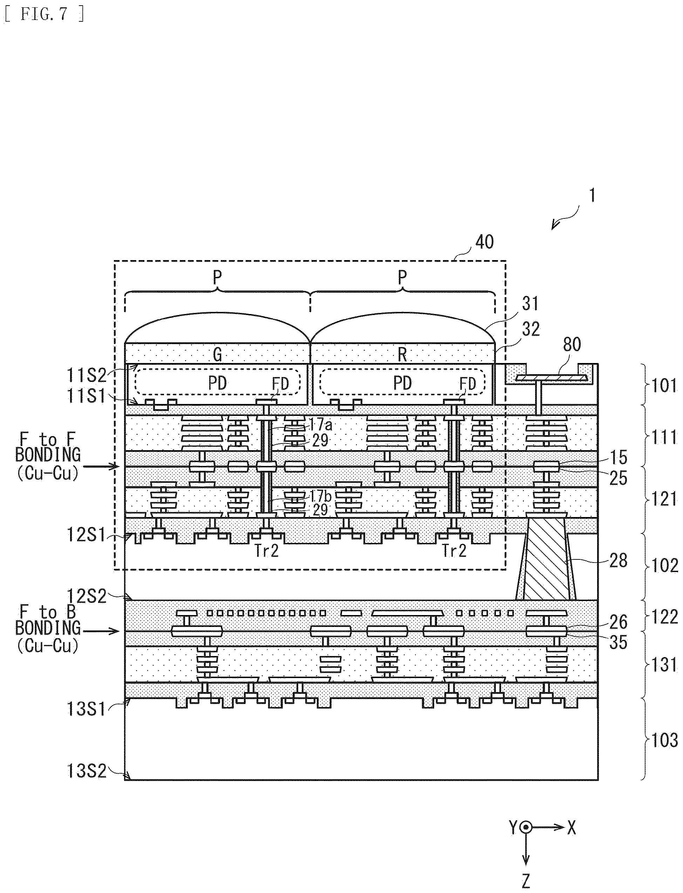

The imaging device 1 may include a protective film around the through-via 17. The protective film may be formed to coat the through-via 17 in the wiring layer. FIG. 7 is a diagram illustrating an example of a cross-sectional configuration of an imaging device according to Modification Example 2. In the example illustrated in FIG. 7, a protective film 29 is provided to cover a periphery of the first through-via 17a, in the wiring layer 111. In addition, the protective film 29 is provided to cover a periphery of the second through-via 17b, in the wiring layer 121. The protective film 29 includes silicon and at least one of oxygen, nitrogen, or carbon. For example, the protective film 29 may be configured by a silicone oxide film.

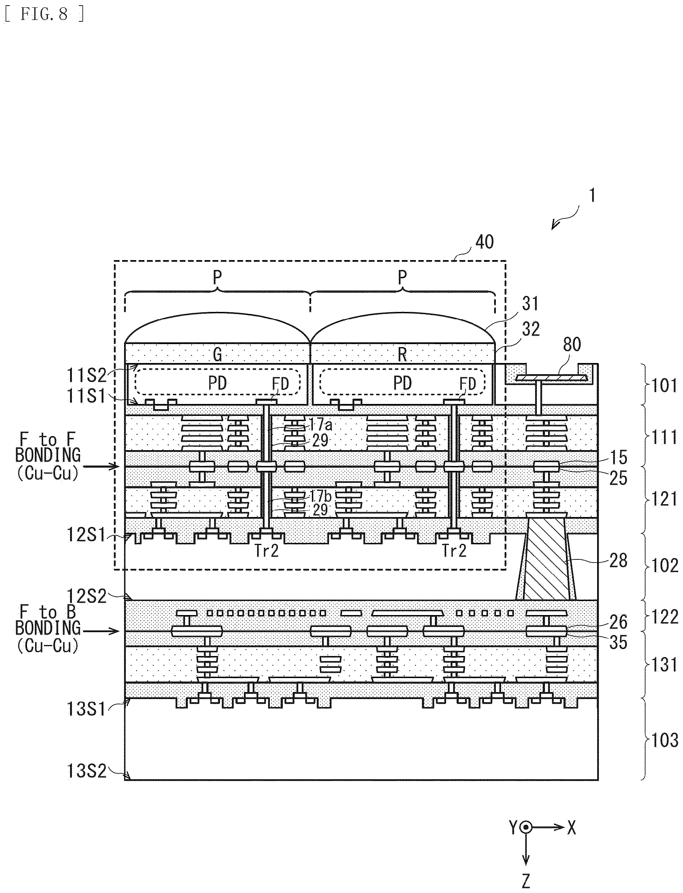

In the present modification example, providing the protective film 29 between the through-via 17 and the insulating film of the wiring layer, e.g., the insulating film configured by a low permittivity material makes it possible to suppress the entry of a metal material used for the through-via 17 into the wiring layer. This makes it possible to prevent an increase in the capacitance to be added to the circuit part coupled to the through-via 17 (e.g., the floating diffusion FD) as well as to prevent the through-via 17 from being shorted (short-circuited) with another wiring line, or the like. It is to be noted that, also in the case of the present modification example, the first through-via 17a may be directly coupled to the circuit element of the first substrate 101, and the second through-via 17b may be directly coupled to the circuit element of the second substrate 102, as illustrated in FIG. 8.

### (2-3. Modification Example 3)

In the foregoing embodiment, the configuration example of the imaging device 1 has been described, but is merely exemplary; the configuration of the imaging device 1 is not limited to the above-described example. The bonding between the through-via and the bonding electrode may be utilized to couple a plurality of substrates to each other. For example, bonding between a plurality of through-vias and a plurality of bonding electrodes allows the first substrate 101 and the second substrate 102 to be coupled to each other.

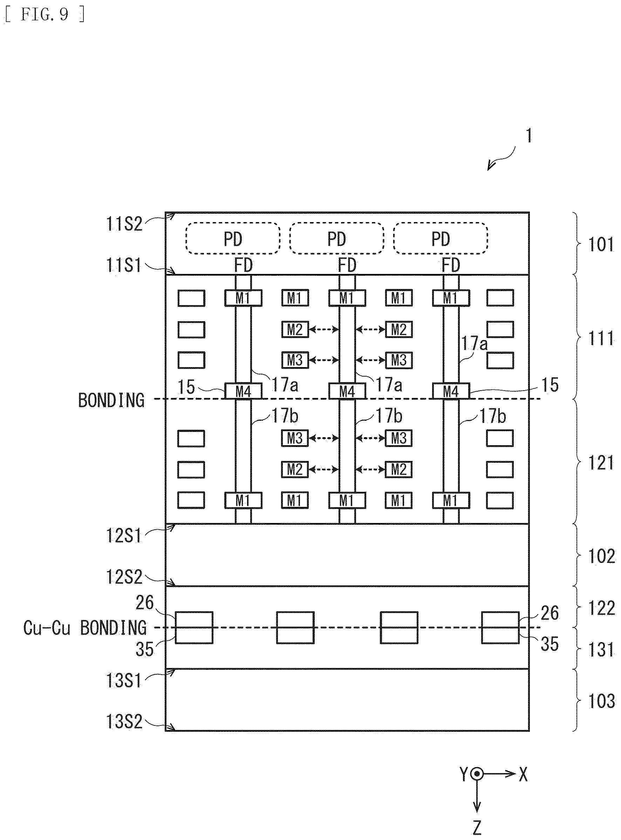

FIG. 9 is a diagram illustrating an example of a cross-sectional configuration of an imaging device according to Modification Example 3. FIG. 9 schematically illustrates a cross-sectional configuration example of a portion of the imaging device 1. As illustrated in FIG. 9, the second through-via 17b may be coupled to the electrode 15 as the bonding electrode. The first substrate 101 and the second substrate 102 are stacked by bonding between the second through-via 17b and the electrode 15. The first substrate 101 and the second substrate 102 of the imaging device 1 have a bonding surface between the second through-via 17b and the electrode 15.

In the example illustrated in FIG. 9, the second through-via 17b is coupled to the electrode 15 of the wiring layer 111 without passing through the second layer to fourth layer wiring lines in the wiring layer 121. In a direction orthogonal to the stacking direction of the first substrate 101 and the second substrate 102 (Z-axis direction in FIG. 9), a width (area) of the second through-via 17b is smaller than a width of the electrode 15 as the bonding electrode.

In the imaging device 1, the floating diffusion FD provided in the first substrate 101 is electrically coupled to the readout circuit 45 of the second substrate 102 via the bonding electrode 15 on a side of the first substrate 101 and the second through-via 17b. It is possible to reduce a capacitance to be added to the floating diffusion FD, as compared with the case where the floating diffusion FD and the readout circuit 45 are coupled to each other using the two bonding electrodes on the side of the first substrate 101 and a side of the second substrate 102. It is therefore possible to improve the conversion efficiency. In addition, it is possible to suppress occurrence of a decrease in a withstand voltage between wiring lines of the imaging device 1 and degradation in the characteristics of the imaging device 1.

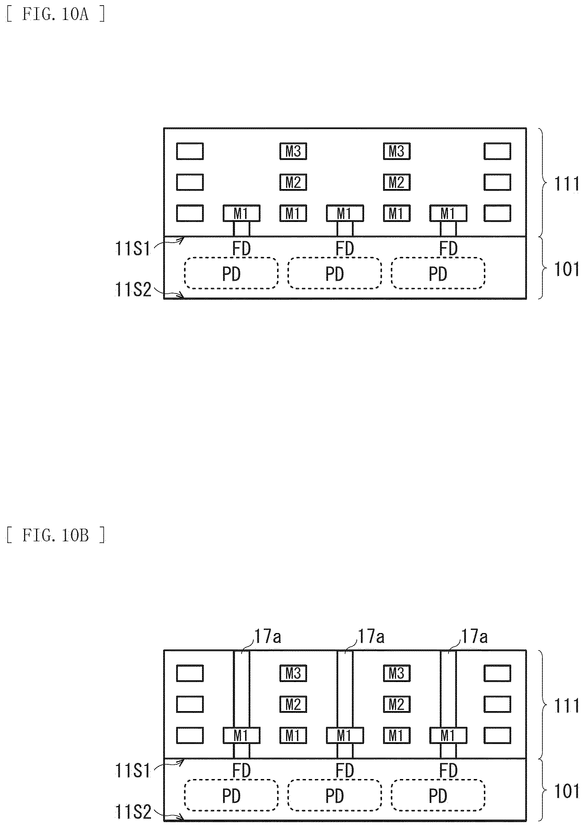

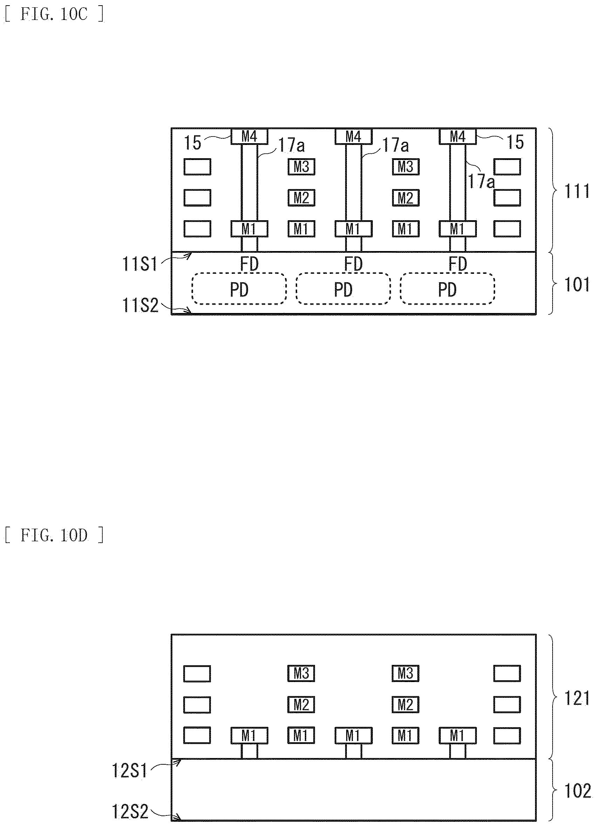

FIGs. 10A to 10F are each an explanatory diagram of an example of a manufacturing method of the imaging device according to Modification Example 3. As illustrated in FIG. 10A, the wiring layer 111 is formed on the first surface 11S1 of the first substrate 101. In addition, as illustrated in FIG. 10B, the first through-via 17a is formed in the wiring layer 111. Then, as illustrated in FIG. 10C, the electrode 15 as the bonding electrode is formed in the wiring layer 111.

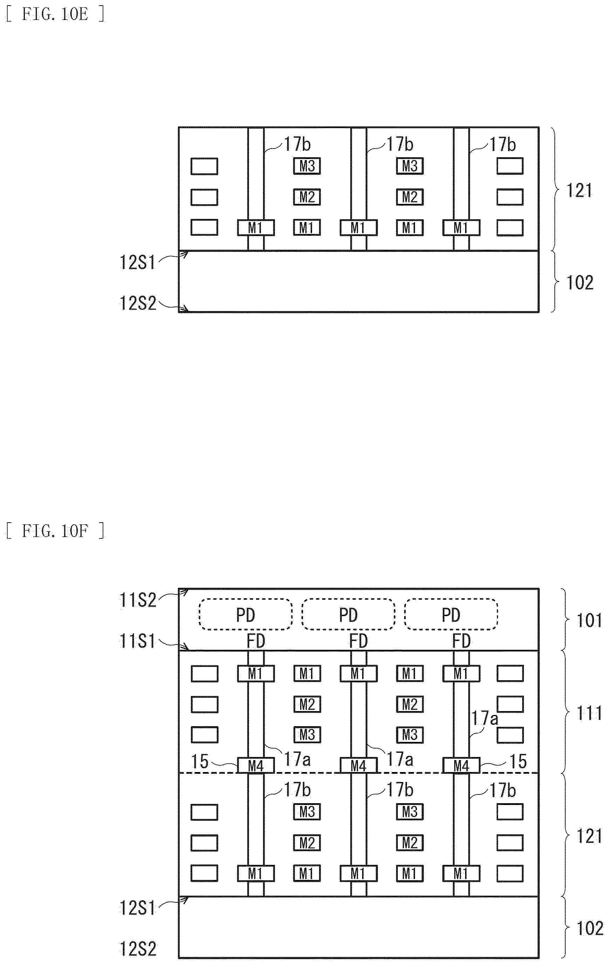

As illustrated in FIG. 10D, the wiring layer 121 is formed on the first surface 12S1 of the second substrate 102. In addition, as illustrated in FIG. 10E, the second through-via 17b is formed in the wiring layer 121. Then, as illustrated in FIG. 10F, the first substrate 101 and the second substrate 102 are bonded to each other by the plurality of electrodes 15 and the plurality of second through-vias 17b to allow the first surface 11S1 and first surface 12S1 to be opposed to each other. The above-described manufacturing method enables the imaging device 1 having the structure illustrated in FIG. 9 to be manufactured. It is to be noted that the above-described manufacturing method is merely exemplary, and another manufacturing method may be adopted.

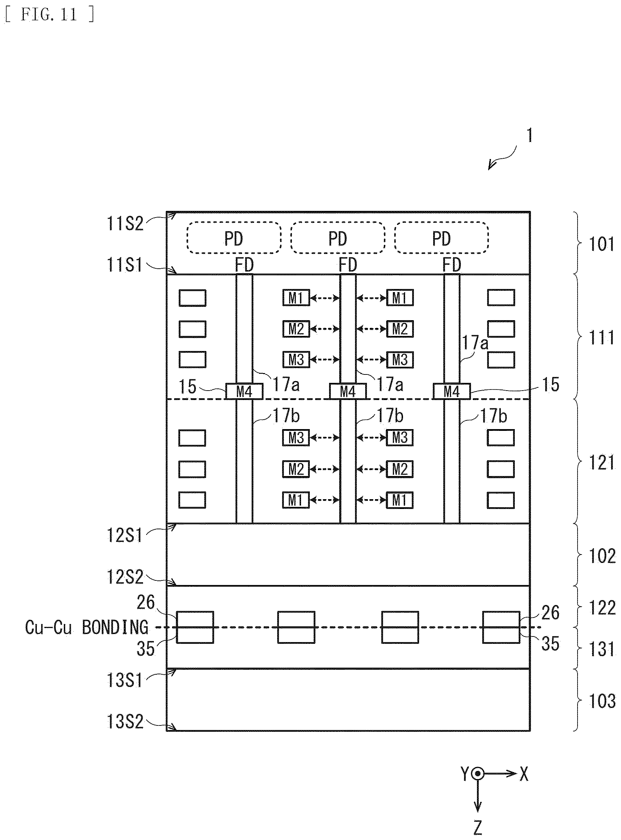

FIGs. 11 to 13 are each a diagram illustrating another example of the cross-sectional configuration of the imaging device according to Modification Example 3. As schematically illustrated in FIG. 11, the first through-via 17a may be directly coupled to the circuit element of the first substrate 101, and the second through-via 17b may be directly coupled to the circuit element of the second substrate 102. In the example illustrated in FIG. 11, the second through-via 17b is coupled to the electrode 15 of the wiring layer 111 without passing through the first layer to fourth layer wiring lines in the wiring layer 121.

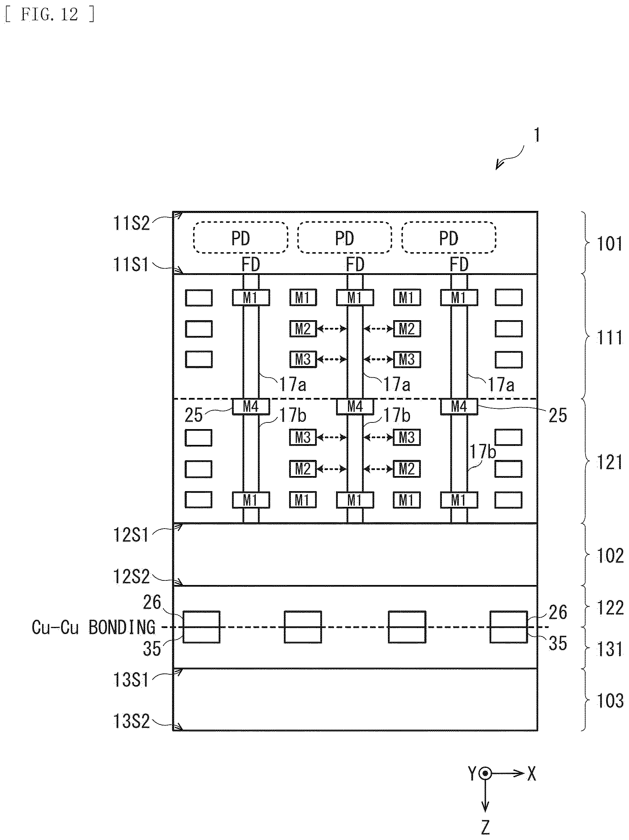

As in the example illustrated in FIG. 12, the first through-via 17a may be coupled to the electrode 25 as the bonding electrode. The first substrate 101 and the second substrate 102 are stacked by bonding between the first through-via 17a and the electrode 25. The first substrate 101 and the second substrate 102 of the imaging device 1 have a bonding surface between the first through-via 17a and the electrode 25.

In the example illustrated in FIG. 12, the first through-via 17a is coupled to the electrode 25 of the wiring layer 121 without passing through the second layer to fourth layer wiring lines in the wiring layer 111. In a direction orthogonal to the stacking direction of the first substrate 101 and the second substrate 102 (Z-axis direction in FIG. 9), a width (area) of the first through-via 17a is smaller than a width of the electrode 25 as the bonding electrode.

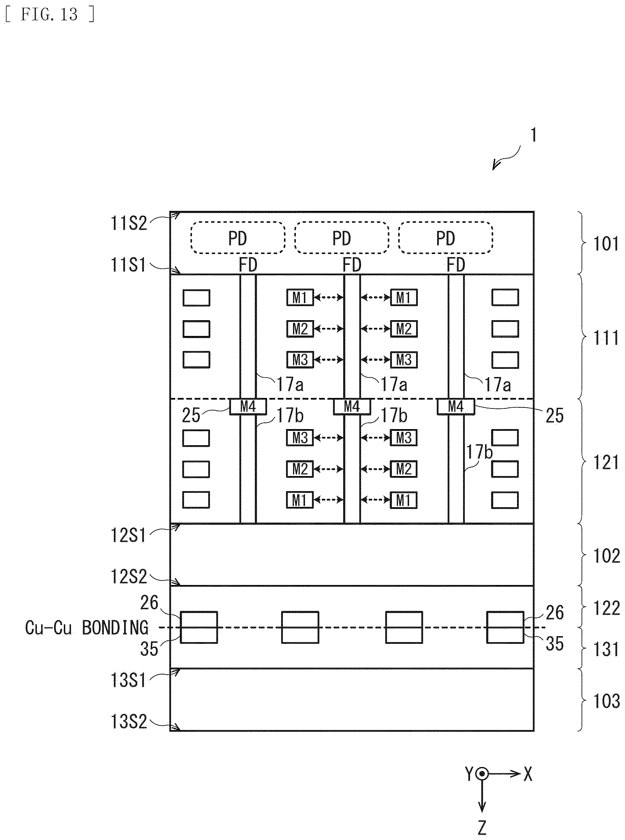

It is to be noted that, as illustrated in FIG. 13, the first through-via 17a may be directly coupled to the circuit element of the first substrate 101, and the second through-via 17b may be directly coupled to the circuit element of the second substrate 102. In the example illustrated in FIG. 13, the first through-via 17a is coupled to the electrode 25 of the wiring layer 121 without passing through the first layer to fourth layer wiring lines in the wiring layer 111.

### (2-4. Modification Example 4)

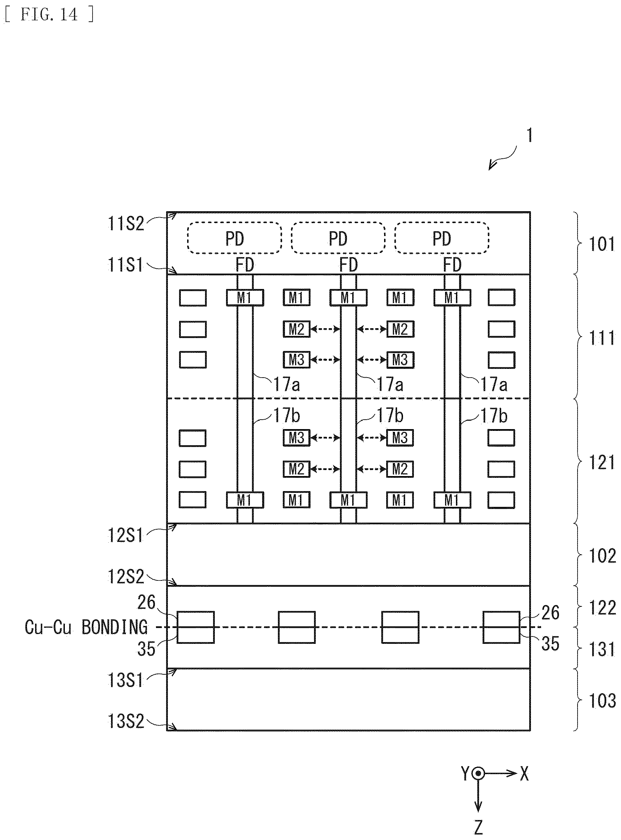

FIG. 14 is a diagram illustrating an example of a cross-sectional configuration of an imaging device according to Modification Example 4. Bonding between through-vias may be utilized to couple a plurality of substrates to each other. For example, the first through-via 17a may be directly coupled to the second through-via 17b. Bonding between the plurality of first through-vias 17a of the first substrate 101 and the plurality of second through-vias 17b of the second substrate 102 allows the first substrate 101 and the second substrate 102 to be coupled to each other.

As illustrated in FIG. 14, the first substrate 101 and the second substrate 102 are stacked by bonding between the first through-via 17a and the second through-via 17b. The first substrate 101 and the second substrate 102 of the imaging device 1 have a bonding surface between the first through-via 17a and the second through-via 17b.

In the example illustrated in FIG. 14, the first through-via 17a is coupled to the second through-via 17b of the wiring layer 121 without passing through the second layer to fourth layer wiring lines in the wiring layer 111. The second through-via 17b is coupled to the first through-via 17a of the wiring layer 111 without passing through the second layer to fourth layer wiring lines in the wiring layer 121.

In the imaging device 1, the floating diffusion FD provided in the first substrate 101 is electrically coupled to the readout circuit 45 of the second substrate 102 by the first through-via 17a and the second through-via 17b. It is therefore possible to reduce a capacitance to be added to the floating diffusion FD.

In the imaging device 1 according to the present modification example, it is possible to secure a space between wiring lines, as compared with the case where the plurality of wiring lines and the plurality of bonding electrodes are used to couple the floating diffusion FD and the readout circuit 45 to each other. It is therefore possible to effectively reduce a capacitance to be added to the floating diffusion FD, and thus to improve the conversion efficiency. In addition, it is possible to suppress occurrence of a decrease in a withstand voltage between wiring lines of the imaging device 1 and degradation in the characteristics of the imaging device 1.

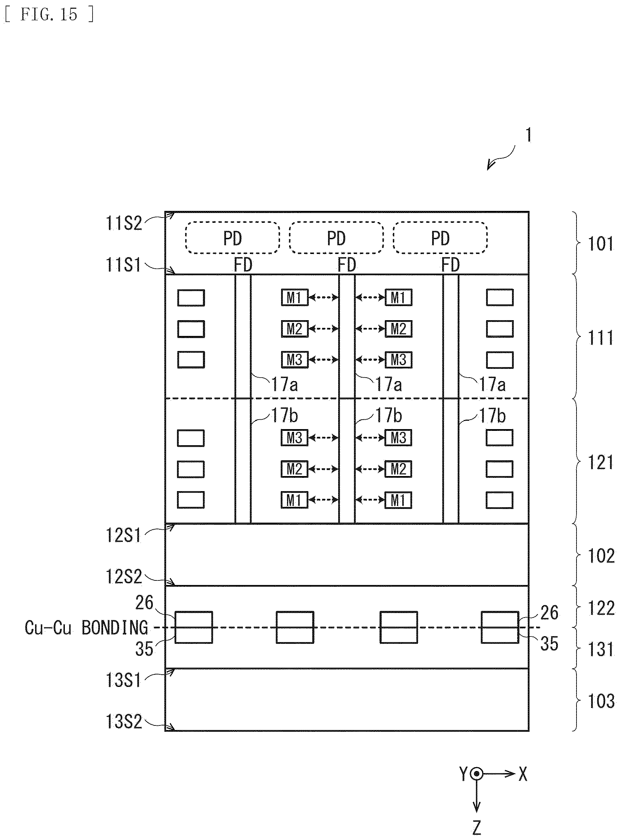

FIG. 15 is a diagram illustrating another example of the cross-sectional configuration of the imaging device according to Modification Example 4. As schematically illustrated in FIG. 15, the first through-via 17a may be directly coupled to the circuit element of the first substrate 101, and the second through-via 17b may be directly coupled to the circuit element of the second substrate 102. In the example illustrated in FIG. 15, the first through-via 17a and the second through-via 17b are coupled to each other without passing through the first layer to fourth layer wiring lines in the wiring layer 111 and the wiring layer 121.

### (2-5. Modification Example 5)

The description has been given, in the foregoing embodiment, of the example in which three-dimensional coupling is achieved by bonding between electrodes (e.g., Cu-Cu bonding). However, as the form of the coupling between the substrates, any of Wafer on Wafer (wafer-on-wafer), Die to wafer (die-to-wafer), and Die to die (die-to-die) may be adopted.

The description has been given above of the example in which the back surface of the second substrate 102 and the front surface of the third substrate 103 are bonded to each other; however, the back surface of the second substrate 102 and the back surface of the third substrate 103 may be bonded to each other. It is to be noted that the third substrate 103 including the row drive section 220, the column signal processing section 250, the image signal processing section 260, and the like may be three-dimensionally bonded or coupled to a substrate different from the second substrate 102.

### <3. Application Example>

The above-described imaging device 1 or the like is applicable, for example, to any type of electronic apparatus with an imaging function including a camera system such as a digital still camera or a video camera, a mobile phone having an imaging function, and the like. FIG. 9 illustrates a schematic configuration of an electronic apparatus 1000.

The electronic apparatus 1000 includes, for example, a lens group 1001, the imaging device 1, a DSP (Digital Signal Processor) circuit 1002, a frame memory 1003, a display unit 1004, a recording unit 1005, an operation unit 1006, and a power supply unit 1007. They are coupled to each other via a bus line 1008.

The lens group 1001 takes in incident light (image light) from a subject, and forms an image on an imaging surface of the imaging device 1. The imaging device 1 converts the amount of incident light formed as an image on the imaging surface by the lens group 1001 into electric signals on a pixel-by-pixel basis, and supplies the DSP circuit 1002 with the electric signals as pixel signals.

The DSP circuit 1002 is a signal processing circuit that processes signals supplied from the imaging device 1. The DSP circuit 1002 outputs image data obtained by processing the signals from the imaging device 1. The frame memory 1003 temporarily holds the image data processed by the DSP circuit 1002 on a frame-by-frame basis.

The display unit 1004 includes, for example, a panel-type display device such as a liquid crystal panel or an organic EL (Electro Luminescence) panel, and records image data of a moving image or a still image captured by the imaging device 1 in a recording medium such as a semiconductor memory or a hard disk.

The operation unit 1006 outputs an operation signal for a variety of functions of the electronic apparatus 1000 in accordance with an operation by a user. The power supply unit 1007 appropriately supplies the DSP circuit 1002, the frame memory 1003, the display unit 1004, the recording unit 1005, and the operation unit 1006 with various kinds of power for operations of these supply targets.

### <4. Practical Application Examples>

### (Example of Practical Application to Mobile Body)

The technology (the present technology) according to the present disclosure is applicable to a variety of products. For example, the technology according to the present disclosure may be achieved as a device mounted on any type of mobile body such as an automobile, an electric vehicle, a hybrid electric vehicle, a motorcycle, a bicycle, a personal mobility, an aircraft, a drone, a vessel, or a robot.

FIG. 10 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 10, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensorthat receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 10, an audio speaker 12061, a display section 12062, and an instrument panel 12063 are illustrated as the output device. The display section 12062 may, for example, include at least one of an on-board display and a head-up display.

FIG. 11 is a diagram depicting an example of the installation position of the imaging section 12031.

In FIG. 11, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 11 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of the mobile body control system to which the technology according to an embodiment of the present disclosure is applicable. The technology according to an embodiment of the present disclosure is applicable to the imaging section 12031, for example, of the configurations described above. Specifically, for example, the imaging device 1 can be applied to the imaging section 12031. Applying the technology according to an embodiment of the present disclosure to the imaging section 12031 enables obtainment of a high-definition photographed image, thus making it possible to perform highly accurate control utilizing the photographed image in the mobile body control system.

### (Example of Practical Application to Endoscopic Surgery System)

The technology according to an embodiment of the present disclosure (present technology) is applicable to various products. For example, the technology according to an embodiment of the present disclosure may be applied to an endoscopic surgery system.

FIG. 12 is a view depicting an example of a schematic configuration of an endoscopic surgery system to which the technology according to an embodiment of the present disclosure (present technology) can be applied.

In FIG. 12, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

FIG. 13 is a block diagram depicting an example of a functional configuration of the camera head 11102 and the CCU 11201 depicted in FIG. 12.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given hereinabove of one example of the endoscopic surgery system, to which the technology according to an embodiment of the present disclosure is applicable. The technology according to an embodiment of the present disclosure is suitably applicable to, for example, the image pickup unit 11402 provided in the camera head 11102 of the endoscope 11100 of the configurations described above. Applying the technology according to an embodiment of the present disclosure to the image pickup unit 11402 enables the image pickup unit 11402 to have high sensitivity, thus making it possible to provide the endoscope 11100 having high definition.

Although the description has been given hereinabove of the present disclosure with reference to the embodiment, the modification examples, the application example, and the practical application examples, the present technology is not limited to the foregoing embodiment and the like, and may be modified in a wide variety of ways. For example, although the foregoing modification examples have been described as modification examples of the foregoing embodiment, the configurations of the respective modification examples may be combined as appropriate.

In addition, the light-receiving device of the present disclosure may be in the form of a module in which an imaging section and a signal processing section or an optical system are packaged as a whole.

Further, the description has been given, in the foregoing embodiment and the like, by exemplifying the imaging device that converts the amount of incident light formed as an image on an imaging surface via the optical lens system into electric signals on a pixel-by-pixel basis and outputs the electric signals as pixel signals. However, the light-receiving device of the present disclosure is not limited to such an imaging device. For example, it is sufficient for the light-receiving device of the present disclosure to be one that receives incident light and converts the light into electric charge. A signal to be outputted may be a signal of image information or a signal of distance measurement information.

In the light-receiving device of an embodiment of the present disclosure, a first substrate including a photoelectric conversion section and an accumulation section and a second substrate including a readout circuit are stacked to allow a surface of the first substrate on which an element is formed and a surface of the second substrate on which an element is formed to be opposed to each other. The light-receiving device is provided with a via that penetrates a plurality of layers in a wiring layer to electrically couple the accumulation section and the readout circuit to each other. It is therefore possible to reduce a capacitance to be added to the accumulation section, and thus to improve the conversion efficiency.

It is to be noted that the effects described herein are merely exemplary and are not limited to the description, and may further include other effects. In addition, the present disclosure may also have the following configurations.
(1) A light-receiving device including:
   a first substrate including a plurality of photoelectric conversion sections that photoelectrically converts light and an accumulation section that accumulates electric charge photoelectrically converted by the photoelectric conversion sections;
   a second substrate stacked on the first substrate, the second substrate including a readout circuit that outputs a first signal based on the electric charge accumulated in the accumulation section; and
   a wiring layer including a via that electrically couples the accumulation section and the readout circuit to each other, in which
   the first substrate and the second substrate are stacked to allow a first surface of the first substrate on which an element is formed and a second surface of the second substrate on which an element is formed to be opposed to each other, and
   the via penetrates a plurality of layers in the wiring layer.
(2) The light-receiving device according to (1), in which
   the first substrate and the second substrate are stacked by bonding between electrodes, and
   the via is directly coupled to the bonded electrodes.
(3) The light-receiving device according to (1) or (2), in which the via is directly coupled to the first substrate.
(4) The light-receiving device according to (3), in which the via is directly coupled to the accumulation section of the first substrate.
(5) The light-receiving device according to (1) or (2), in which the via is directly coupled to the second substrate.
(6) The light-receiving device according to (5), in which the via is directly coupled to a gate of a transistor provided in the second substrate.
(7) The light-receiving device according to (6), in which the transistor includes a transistor of the readout circuit.
(8) The light-receiving device according to (1), in which
   the readout circuit includes an amplification transistor that generates the first signal, and
   the via is electrically coupled to a gate of the amplification transistor.
(9) The light-receiving device according to (8), in which the via is directly coupled to the gate of the amplification transistor.
(10) The light-receiving device according to any one of (1) to (9), in which the via includes tungsten, cobalt, ruthenium, copper, molybdenum, or aluminum.
(11) The light-receiving device according to any one of (1) to (10), in which
   the wiring layer includes an insulating film having a permittivity lower than a permittivity of a silicone oxide film, and
   the via penetrates the insulating film.
(12) The light-receiving device according to (11), including a protective film provided between the via and the insulating film.
(13) The light-receiving device according to (12), in which the protective film includes silicon and at least one of oxygen, nitrogen, or carbon.
(14) The light-receiving device according to any one of (1) to (13), in which the first substrate and the second substrate are stacked by bonding between the via and an electrode.
(15) The light-receiving device according to (14), in which a width of the via is smaller than a width of the electrode in a direction orthogonal to a stacking direction of the first substrate and the second substrate.
(16) The light-receiving device according to any one of (1) to (15), in which
   the wiring layer includes a first wiring layer provided on a side of the first surface of the first substrate and a second wiring layer provided on a side of the second surface of the second substrate, and
   the via includes a first via provided in the first wiring layer and being electrically coupled to the accumulation section and a second via provided in the second wiring layer and electrically coupling the first via and the readout circuit to each other.
(17) The light-receiving device according to (16), in which
   the first via penetrates a plurality of layers in the first wiring layer, and
   the second via penetrates a plurality of layers in the second wiring layer.
(18) The light-receiving device according to (16) or (17), in which the second via is directly coupled to the first via.
(19) The light-receiving device according to any one of (16) to (18), in which the first substrate and the second substrate are stacked by bonding between the first via and the second via.

The present application claims the benefit of Japanese Priority Patent Application JP2021-201271 filed with the Japan Patent Office on December 10, 2021, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A light-receiving device comprising:
a first substrate including a plurality of photoelectric conversion sections that photoelectrically converts light and an accumulation section that accumulates electric charge photoelectrically converted by the photoelectric conversion sections;
a second substrate stacked on the first substrate, the second substrate including a readout circuit that outputs a first signal based on the electric charge accumulated in the accumulation section; and
a wiring layer including a via that electrically couples the accumulation section and the readout circuit to each other, wherein
the first substrate and the second substrate are stacked to allow a first surface of the first substrate on which an element is formed and a second surface of the second substrate on which an element is formed to be opposed to each other, and
the via penetrates a plurality of layers in the wiring layer.

2. The light-receiving device according to claim 1, wherein
the first substrate and the second substrate are stacked by bonding between electrodes, and
the via is directly coupled to the bonded electrodes.

3. The light-receiving device according to claim 1, wherein the via is directly coupled to the first substrate.

4. The light-receiving device according to claim 3, wherein the via is directly coupled to the accumulation section of the first substrate.

5. The light-receiving device according to claim 1, wherein the via is directly coupled to the second substrate.

6. The light-receiving device according to claim 1, wherein the via is directly coupled to a gate of a transistor provided in the second substrate.

7. The light-receiving device according to claim 6, wherein the transistor comprises a transistor of the readout circuit.

8. The light-receiving device according to claim 1, wherein
the readout circuit includes an amplification transistor that generates the first signal, and
the via is electrically coupled to a gate of the amplification transistor.

9. The light-receiving device according to claim 8, wherein the via is directly coupled to the gate of the amplification transistor.

10. The light-receiving device according to claim 1, wherein the via includes tungsten, cobalt, ruthenium, copper, molybdenum, or aluminum.

11. The light-receiving device according to claim 1, wherein
the wiring layer includes an insulating film having a permittivity lower than a permittivity of a silicone oxide film, and
the via penetrates the insulating film.

12. The light-receiving device according to claim 11, comprising a protective film provided between the via and the insulating film.

13. The light-receiving device according to claim 12, wherein the protective film includes silicon and at least one of oxygen, nitrogen, or carbon.

14. The light-receiving device according to claim 1, wherein the first substrate and the second substrate are stacked by bonding between the via and an electrode.

15. The light-receiving device according to claim 14, wherein a width of the via is smaller than a width of the electrode in a direction orthogonal to a stacking direction of the first substrate and the second substrate.

16. The light-receiving device according to claim 1, wherein
the wiring layer includes a first wiring layer provided on a side of the first surface of the first substrate and a second wiring layer provided on a side of the second surface of the second substrate, and
the via includes a first via provided in the first wiring layer and being electrically coupled to the accumulation section and a second via provided in the second wiring layer and electrically coupling the first via and the readout circuit to each other.

17. The light-receiving device according to claim 16, wherein
the first via penetrates a plurality of layers in the first wiring layer, and
the second via penetrates a plurality of layers in the second wiring layer.

18. The light-receiving device according to claim 16, wherein the second via is directly coupled to the first via.

19. The light-receiving device according to claim 16, wherein the first substrate and the second substrate are stacked by bonding between the first via and the second via.
